# EUROPÄISCHE PATENTSCHRIFT

(11) **EP 2 755 249 B1**
(45) Veröffentlichungstag und Bekanntmachung des Hinweises auf die Patenterteilung: **19.10.2016**
(21) Anmeldenummer: 13198006.2
(22) Anmeldetag: 18.12.2013
(51) Int. Cl.: H01L 41/113, H01L 41/047, H01L 41/313

(54) **Piezoelektrischer Sensor und Verfahren zur Herstellung eines piezoelektrischen Bauteils**
Piezoelectric sensor and method of fabrication a piezoelectric device
Capteur piézoélectrique et procédé de fabrication d'un dispositif piézoélectrique

(30) Priorität: 10.01.2013 DE 102013200242
(43) Veröffentlichungstag der Anmeldung: 16.07.2014
(73) Patentinhaber: ROBERT BOSCH GMBH, 70442 Stuttgart (DE)
(72) Erfinder: Melcher, Reinhold, 91052 Erlangen (DE); Guenther, Michael, 70469 Stuttgart (DE)

(56) Entgegenhaltungen:
- EP-A1- 1 054 459
- WO-A1-2007/138346
- WO-A1-2013/011217
- JP-A- 2008 172 106
- US-A- 6 042 028
- US-A1- 2003 107 867
- US-A1- 2008 199 332

## Beschreibung

### Stand der Technik

Die Erfindung betrifft einen piezoelektrischen Sensor, sowie ein Verfahren zur Herstellung solch eines piezoelektrischen Sensors.

Speziell betrifft die Erfindung das Gebiet der piezokeramischen Drucksensoren, die zur Druckmessung bei Kraftfahrzeugen zum Einsatz kommen.

Aus der DE 10 2010 000 827 A1 ist ein Kraftstoffinjektor mit einem Kraft- oder Drucksensor bekannt. Bei dem bekannten Kraftstoffinjektor ist der Kraft- oder Drucksensor einem Steuerraum zugeordnet, dessen Druck die Hübe beziehungsweise Stellungen einer Düsennadel bestimmt. Über den Kraft- oder Drucksensor kann der Verlauf des Steuerraumdruckes erfasst werden.

Bei der Ausgestaltung eines piezoelektrischen Drucksensors ist es denkbar, dass keramische Schichten und dazwischen angeordnete Elektrodenschichten vorgesehen sind, wobei zur Kontaktierung einer Elektrodenschicht die zugeordnete keramische Schicht an dieser Stelle eine Aussparung aufweist. Die Kontaktierung kann dann durch Löten erfolgen. Hierbei können auch zwei unterschiedlich große keramische Schichten vorgesehen sein, um einen Zugriff auf die Elektrodenschicht zuzulassen. Der Kontakt mit einer elektrischen Schaltung kann beispielsweise auch durch Bonden, Anschweißen oder Klemmen erfolgen. Diese Ausgestaltungen haben den Nachteil, dass zum einen die wirksame Querschnittsfläche zur Signalgewinnung in Bezug auf den benötigten Bauraum reduziert ist. Dies wirkt sich ungünstig auf das Sensorsignal aus. Außerdem wird für die Verbindung eine zusätzlicher Platz zum Kontaktieren benötigt. Speziell bei einer Klemmverbindung muss auch ein Platz für den Klemmpartner gewährleistet werden.

Außerdem ergibt sich insbesondere bei Anwendungen, wie der Druckmessung in Kraftstoffinjektoren das Problem, dass eine hohe Druckbeständigkeit gewährleistet werden muss.

Aus der DE 10 2009 000 192 A1 ist ein Sinterwerkstoff bekannt, bei dem metallische und/oder keramische, beim Sinterprozess nicht ausgasende Hilfspartikel vorgesehen sind. Die Hilfspartikel können hierbei als Abstandshalter dienen, um eine Schichtdicke vorzugeben.

Aus der US 2003/0107867 A1 ist ein keramischer Vielschichtkörper bekannt. Bei der Herstellung wird dieser bei 80°C verpresst. Später erfolgt ein Sintern bei 1100°C.

Aus der WO 2013/011217 A1, die als nachveröffentlichter Stand der Technik im Sinne von Art. 54 (3) EPÜ gilt, ist ein Ultraschalltransduktor bekannt. Dieser Ultraschalltransduktor kann als Aktuator in einem Injektor für Brennkraftmaschinen zum Einsatz kommen.

### Offenbarung der Erfindung

Das erfindungsgemäße piezoelektrische Bauteil mit den Merkmalen des Anspruchs 1 und das erfindungsgemäße Verfahren mit den Merkmalen des Anspruchs 8 haben den Vorteil, dass ein verbesserter Aufbau des piezoelektrischen Bauteils und eine verbesserte Funktionsweise ermöglicht sind. Insbesondere können über die Lebensdauer des piezoelektrischen Bauteils auftretende, systematische Signalabweichungen verringert werden.

Durch die in den Unteransprüchen aufgeführten Maßnahmen sind vorteilhafte Weiterbildungen des im Anspruch 1 angegebenen piezoelektrischen Bauteils und des im Anspruch 8 angegebenen Verfahrens möglich.

Erfindungsgemäss, wird die Kontaktschicht durch eine Druckbeaufschlagung der ersten piezokeramischen Schicht gegen die zweite piezokeramische Schicht über den Fügewerkstoff zwischen die erste piezokeramische Schicht und die zweite piezokeramische Schicht eingefügt. Ferner wird der Fügewerkstoff durch Sintern mit der Kontaktschicht verbunden und der Fügewerkstoff durch Sintern mit der ersten piezokeramischen Schicht verbunden. Speziell ist es eine Kombination aus einer Druckbeaufschlagung und einem Verbinden durch gleichzeitiges Sintern. Durch die Druckbeaufschlagung des Fügewerkstoffs bei der Herstellung werden Veränderungen des Fügematerials im Betrieb vermieden. Speziell kann die Druckbeaufschlagung hierbei an den im Anwendungsfall im Normalbetrieb auftretenden Druck angepasst sein. Wird beispielsweise genau der Druck zur Druckbeaufschlagung verwendet, der auch in der Anwendung im Normalbetrieb zwischen der ersten piezokeramischen Schicht und der zweiten piezokeramischen Schicht auf den Fügewerkstoff einwirkt, dann werden Veränderungen des Fügematerials unter den beim Betrieb anliegenden Drücken und Temperaturen zumindest weitgehend ausgeschlossen. Über die Lebensdauer auftretende systematische Eigenschaftsänderungen werden somit verhindert. Insbesondere werden systematische Signaländerungen vermieden.

In vorteilhafter Weise basiert der Fügewerkstoff auf Silber oder einer Silberverbindung. Hierbei kann insbesondere eine Silbersintertechnik als druckbeaufschlagter Prozess zum Einsatz kommen. Der Fügewerkstoff kann hierbei auf Silberpartikeln basieren, die unter Umgehung einer schmelzflüssigen Phase während der Prozessierung einen elektrischen und mechanischen Kontakt ausbilden.

Ferner ist es vorteilhaft, dass der Fügewerkstoff auf Silber oder einer Silberverbindung und/oder einer Silberlegierung basiert, wobei das Silber beziehungsweise die Silberverbindung und/oder die Silberlegierung durch einen weiteren Werkstoff gefüllt ist. Hierdurch können geeignete Werkstoffe zum Beispiel als Hilfsstoffe in den ganz oder teilweise aus Silber bestehenden Grundwerkstoff eingebracht werden, um den Fügewerkstoff zu bilden.

Die elektrisch leitende Kontaktschicht kann hierbei in vorteilhafter Weise durch eine metallische Einlage gebildet sein. Somit kann die elektrisch leitende Kontaktschicht insbesondere durch eine dünne Metalllage gebildet sein, die eine hohe Leitfähigkeit und eine homogene Gefügestruktur hat. Dadurch ist eine optimale Signalgewinnung möglich. Hierbei kann die Kontaktschicht außerdem aus dem Verbund mit der ersten piezokeramischen Schicht und der zweiten piezokeramischen Schicht ragen. Dies ermöglicht eine optimale Signalabnahme. Ferner kann der wirksame Querschnitt zur Signalgewinnung in Bezug auf den benötigten Bauraum optimiert werden. Insbesondere ist es somit vorteilhaft, dass die erste piezokeramische Schicht und die zweite piezokeramische Schicht mit der dazwischen eingefügten Kontaktschicht über den Fügewerkstoff mit deckungsgleichen Verbindungs-Querschnittsflächen verbunden sind. Aussparungen an einer der keramischen Schichten oder unterschiedlich große Schichten, die zusätzlichen Platz zum Kontaktieren frei lassen, sind somit nicht erforderlich.

Durch die Einbringung des Fügewerkstoffs ergibt sich außerdem der Vorteil, dass Toleranzen, Welligkeiten oder Oberflächenunebenheiten der Kontaktschicht oder der keramischen Schichten in einfacher Weise bei der Herstellung ausgeglichen werden können.

Bei der Herstellung des piezoelektrischen Bauteils ist es ferner vorteilhaft, dass die elektrisch leitende Kontaktschicht in eine zur Ausbildung des Fügewerkstoffs dienende Paste eingetaucht wird, um die elektrisch leitende Kontaktschicht mit dem Fügewerkstoff zu versehen. Hierbei kann unter anderem durch die Viskosität der Paste die an der Kontaktschicht anhaftende Menge des Fügewerkstoffs eingestellt werden. Insbesondere kann dadurch die Menge des Fügewerkstoffs auf dem erforderlichen Mindestwert reduziert werden, so dass zum einen der Abstand zwischen den piezokeramischen Schichten reduziert wird, was sich günstig auf die Signalgewinnung auswirkt, und zum anderen ein Materialverbrauch, insbesondere die benötigte Menge an Silber, reduziert ist.

### Kurze Beschreibung der Zeichnungen

Bevorzugte Ausführungsbeispiele der Erfindung sind in der nachfolgenden Beschreibung unter Bezugnahme auf die beigefügten Zeichnungen, in denen sich entsprechende Elemente mit übereinstimmenden Bezugszeichen versehen sind, näher erläutert. Es zeigen:
Fig. 1 ein piezoelektrisches Bauteil entsprechend einem ersten Ausführungsbeispiel der Erfindung in einer schematischen Schnittdarstellung;
Fig. 2 ein piezoelektrisches Bauteil entsprechend einem zweiten Ausführungsbeispiel der Erfindung mit einem Kontaktpartner in einer schematischen Schnittdarstellung und
Fig. 3 ein Prozessflussdiagramm zur Erläuterung eines Verfahrens zur Herstellung des in Fig. 2 dargestellten piezoelektrischen Bauteils entsprechend dem zweiten Ausführungsbeispiel der Erfindung.

### Ausführungsformen der Erfindung

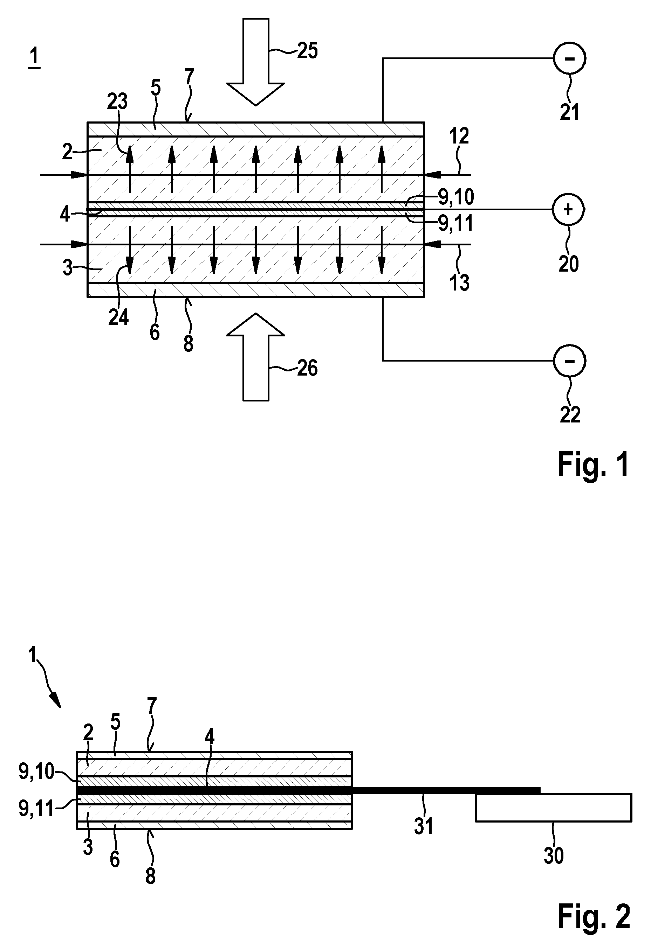

Fig. 1 zeigt ein piezoelektrisches Bauteil 1 entsprechend einem ersten Ausführungsbeispiel in einer schematischen Schnittdarstellung. Das piezoelektrische Bauteil 1 dient vorzugsweise als piezoelektrischer Sensor 1. Der piezoelektrische Sensor 1 kann insbesondere bei Brennstoffeinspritzanlagen zum Einsatz kommen. Beispielsweise kann der piezoelektrische Sensor 1 als Nadelschließsensor dienen, der ein Schließen einer Ventilnadel eines Brennstoffeinspritzventils überwacht. Hierbei kann der Sensor 1 auch einen Druckverlauf innerhalb eines Brennstoffraums des Brennstoffeinspritzventils messen. Der Sensor 1 kann auch als Brennraumdrucksensor 1 ausgestaltet sein, der direkt oder indirekt den Druck in einem Brennraum einer Brennkraftmaschine misst. Der piezoelektrische Sensor 1 eignet sich allerdings auch für andere Anwendungsfälle, insbesondere im Kraftfahrzeugbereich. Speziell kann der Sensor 1 auch als Betriebsmittelsensor für Hydraulik- oder Pneumatikanwendungen zum Einsatz kommen.

Der piezoelektrische Sensor 1 weist eine erste piezokeramische Schicht 2 und eine zweite piezokeramische Schicht 3 auf. Ferner weist der piezoelektrische Sensor 1 eine elektrisch leitende Kontaktschicht 4 auf, die zwischen der ersten piezokeramischen Schicht 2 und der zweiten piezokeramischen Schicht 3 angeordnet ist. In diesem Ausführungsbeispiel sind auf die piezokeramischen Schichten 2, 3 außerdem elektrisch leitende Kontaktschichten 5, 6 aufgebracht, die Außenseiten 7, 8 des Sensors 1 bilden.

Somit ist in diesem Ausführungsbeispiel ein Aufbau mit zwei piezokeramischen Schichten 2, 3 verwirklicht. In einer nicht erfinderischen Ausführungsform können allerdings auch mehr als zwei piezokeramische Schichten 2, 3 vorgesehen sein.

Die Kontaktschicht 4 ist über einen Fügewerkstoff 9 zwischen die erste piezokeramische Schicht 2 und die zweite piezokeramische Schicht 3 eingefügt. Ein erster Teil 10 des Fügewerkstoffs 9 befindet sich hierbei zwischen der Kontaktschicht 4 und der ersten piezokeramischen Schicht 2. Ein zweiter Teil 11 des Fügewerkstoffs 9 befindet sich hierbei zwischen der Kontaktschicht 4 und der zweiten piezokeramischen Schicht 3. Durch den Fügewerkstoff 9 wird die Kontaktschicht 4 mit den angrenzenden piezokeramischen Schichten 2, 3 verbunden. Der Fügewerkstoff 9 dient hierbei auch zum Ausgleich von Toleranzen, Welligkeiten, Unebenheiten und dergleichen, die an der Kontaktschicht 4 beziehungsweise an den piezokeramischen Schichten 2, 3 auftreten können. Die Teile 10, 11 des Fügewerkstoffs 9 können in einzelnen Bereichen, insbesondere in Randbereichen, auch ineinander übergehen. Dies ist beispielsweise in einem Fall denkbar, in dem sich die Kontaktschicht 4 nicht über einen gesamten Querschnitt 12 der ersten piezokeramischen Schicht 2 beziehungsweise einen Querschnitt 13 der zweiten piezokeramischen Schicht 3 erstreckt, so dass Randbereiche zwischen den piezokeramischen Schichten 2, 3 durch den Fügewerkstoff 9 aufgefüllt werden.

Die Kontaktschicht 4 ist mit einem Pol 20 verbunden, der in diesem Ausführungsbeispiel als Pluspol für das Messsignal dient. Die Kontaktschicht 5 ist mit einem Pol 21 verbunden, der als Minuspol dient. Die Kontaktschicht 6 ist mit einem Pol 22 verbunden, der ebenfalls als Minuspol dient. Die piezokeramischen Schichten 2, 3 sind in dem Sinn gleichpolig orientiert, dass die Pole 21, 22 gemeinsam auf Masse kontaktiert werden können, so dass für den Abgriff des Messsignals am Pol 20 nur eine gegenüber Masse isolierte Verbindung, insbesondere ein Verbindungskabel, erforderlich ist. Speziell können die Pole 21, 22 mit einem Gehäuse verbunden sein. Die Polarisierung der piezokeramischen Schichten 2, 3 ist durch Pfeile 23, 24 veranschaulicht, wobei zur Vereinfachung der Darstellung nur die Pfeile 23, 24 gekennzeichnet sind.

Im Betrieb wird die erste piezokeramische Schicht 2 gegen die zweite piezokeramische Schicht 3 mit einer Kraft 25 beaufschlagt, wobei sich eine betragsmäßig gleich große, aber entgegen gerichtete Stützkraft 26 ergibt. Die Kraft 25 und die Stützkraft 26 führen zu einer Druckbeaufschlagung der piezokeramischen Schichten 2, 3, so dass über den piezoelektrischen Effekt das Messsignal erzeugt wird. Hierbei wird außerdem der Fügewerkstoff 9 mit Druck beaufschlagt.

Bei der Herstellung des Sensor 1 erfolgt die Einfügung der Kontaktschicht 4 zwischen die piezokeramischen Schichten 2, 3 über den Fügewerkstoff 9 bei einer Druckbeaufschlagung. Speziell kann die Druckbeaufschlagung hier so gewählt sein, dass diese den im Betrieb durch die Kraft 25 wirkenden Drücken entspricht. Bei den im Betrieb anliegenden Temperaturen und Drücken kommt es dann zu keiner wesentlichen Veränderung in der Werkstoffstruktur und somit zu keinen Änderungen der Werkstoffeigenschaften des Fügewerkstoffs 9. Die Kontaktschicht 4 ist vorzugsweise durch eine metallische Einlage gebildet, die somit druckbeständig ist.

Der Fügewerkstoff 9 kann auf Silber oder einer Silberverbindung basieren.

In diesem Ausführungsbeispiel sind die erste piezokeramische Schicht 2 und die zweite piezokeramische Schicht 3 mit der dazwischen eingefügten Kontaktschicht 4 über den Fügewerkstoff 9 mit zumindest näherungsweise deckungsgleichen Verbindungs-Querschnittsflächen verbunden, die gleich den Querschnitten 12, 13 der piezokeramischen Schichten 2, 3 sind. Somit können die piezokeramischen Schichten 2, 3 mit deckungsgleichen Querschnitten 12, 13 ausgeführt werden.

Fig. 2 zeigt ein piezoelektrisches Bauteil 1, insbesondere einen piezoelektrischen Sensor 1, entsprechend einem zweiten Ausführungsbeispiel mit einem Kontaktpartner 30 in einer schematischen Schnittdarstellung. In diesem Ausführungsbeispiel ragt die Kontaktschicht 4 aus dem Verbund mit der ersten piezokeramischen Schicht 2 und der zweiten piezokeramischen Schicht 3 heraus. Hierdurch ist ein Kontaktierungsfortsatz 31 gebildet, der eine einfache Kontaktierung an dem Kontaktpartner 30 ermöglicht. Je nach Ausgestaltung der Kontaktschicht 4 ist hierbei auch ein Umformen, insbesondere Umbiegen, des Kontaktierungsfortsatzes 31 möglich. Außerdem kann der Kontaktierungsfortsatz 31 bereits vor dem Einbringen der Kontaktschicht 4 in den Verbund geeignet ausgestaltet werden. Beispielsweise ist eine laschen- oder stiftförmige Ausgestaltung des Kontaktierungsfortsatzes 31 möglich.

Somit ist ein Aufbau des Sensors 1 möglich, bei dem gleichzeitig die Außenkontaktierung bei der Herstellung über den Kontaktierungsfortsatz 31 sowie über die Kontaktschichten 5, 6, die die Außenseiten 7, 8 des Sensors 1 bilden, realisiert ist. Ferner ist der Sensor 1 durch den bei der Herstellung aufgebrachten Druck stabil gegenüber den Einsatzbedingungen.

Die Verbindung des Kontaktierungsfortsatzes 31 mit dem Kontaktpartner 30 kann außerdem in einem gewissen Abstand im Verbund mit den piezokeramischen Schichten 2, 3 und dem Fügewerkstoff 2, 3 ausgebildet werden, so dass eine Beschädigung, insbesondere eine thermische Beschädigung, verhindert ist.

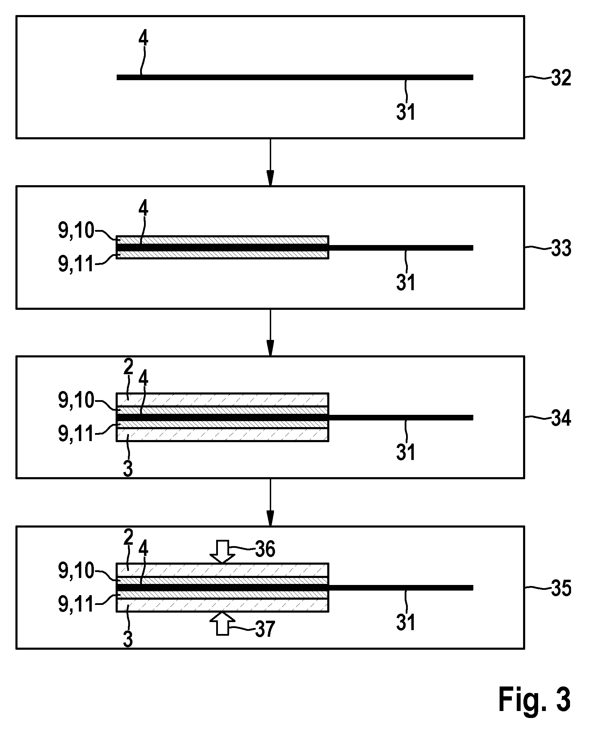

Fig. 3 zeigt ein Prozessflussdiagramm zur Erläuterung eines Verfahrens zur Herstellung des in Fig. 2 dargestellten piezoelektrischen Bauteils 1 entsprechend dem zweiten Ausführungsbeispiel. Zur Erläuterung zeigt das Prozessflussdiagramm aufeinander folgende Schritte 32 bis 35 während der Herstellung. Hierbei können noch weitere Schritte vorgesehen sein. Insbesondere sind auch weitere Zwischenschritte möglich.

Im Schritt 32 wird die Kontaktschicht 4 geeignet vorgefertigt. Hierbei ist ein geeigneter Zuschnitt realisierbar. Insbesondere kann die Außenkontur der Kontaktschicht 4 durch Stanzen festgelegt werden.

Im Schritt 33, der auf den Schritt 32 folgt, wird die Kontaktschicht 4 teilweise in eine Paste für den Fügewerkstoff 9 eingetaucht. Der Kontaktierungsfortsatz 31 wird hierbei nicht in die Paste eingetaucht. Dadurch bleibt der Kontaktierungsfortsatz 31 frei.

Im Schritt 34, der auf den Schritt 33 folgt, wird die Kontaktschicht 4 mit dem Fügewerkstoff 9 zwischen den piezokeramischen Schichten 2, 3 angeordnet. Der Fügewerkstoff 9 füllt hierbei den Raum zwischen der Kontaktschicht 4 und den angrenzenden piezokeramischen Schichten 2, 3 aus. Da die Kontaktschicht 4 aus einem metallischen Werkstoff gebildet ist, ist eine gewisse plastische Verformung der Kontaktschicht 4 möglich. Dies ermöglicht einen gewissen Toleranzausgleich. Ferner passt sich der im Schritt 34 noch pastenförmige Fügewerkstoff 9 an die angrenzenden piezokeramischen Schichten 2, 3 sowie die Kontaktschicht 4 an.

Da die piezokeramischen Schichten 2, 3 in der Regel bruchempfindlich sind, kann hierdurch die Bruchwahrscheinlichkeit bei der Herstellung und im Betrieb des Sensors 1 reduziert werden. Hierbei kann gegebenenfalls auch auf eine Nachbearbeitung der piezokeramischen Schichten 2, 3, insbesondere ein Schleifen oder Polieren, verzichtet werden, wenn bereits ein ausreichender Toleranzausgleich durch die mit dem Fügewerkstoff 9 versehene Kontaktschicht 4 gegeben ist.

Durch die Kontaktschicht 4, die aus einem kostengünstigen metallischen Werkstoff gebildet sein kann, kann die Dicke des elektrisch leitenden Verbunds aus der Kontaktschicht 4 und dem Fügewerkstoff 9 eingestellt werden. Somit kann der Anteil des vorzugsweise aus Silber gebildeten Fügewerkstoffs 9 auf das erforderliche Minimum reduziert werden. Da auch die Kontaktschicht 4 einen Toleranzausgleich, insbesondere durch plastische Verformung, ermöglicht, kann die Menge des Fügewerkstoffs 9 klein sein.

Im Schritt 35, der auf den Schritt 34 folgt, erfolgt ein Sintern, wobei die erste piezokeramische Schicht 2 gleichzeitig gegen die zweite piezokeramische Schicht 3 mit einem Druck beaufschlagt wird. Die Beaufschlagung mit solch einem Druck ist in der Fig. 3 durch Kräfte 36, 37 veranschaulicht, die einander entgegen gerichtet sind. Durch diesen druckbeaufschlagten Prozessschritt werden aus den Silberpartikeln der Paste für den Fügewerkstoff 9 unter Umgehung der schmelzflüssigen Phase ein elektrischer und mechanischer Kontakt mit der Kontaktschicht 4 sowie ein mechanischer Kontakt mit den piezokeramischen Schichten 2, 3 ausgebildet. Die sich ergebende Werkstoffstruktur des Fügewerkstoffs 9 ist hierbei durch den aufgebrachten Druck beeinflusst. Insbesondere ergibt sich ein Unterschied gegenüber einem Sintern ohne Druckbeaufschlagung. Der piezoelektrische Sensor 1 zeichnet sich daher durch vorbestimmte Eigenschaften aus, die sich im Betrieb bei hohen Drücken nicht mehr ändern oder zumindest nur noch einer reduzierten Änderung unterliegen.

Durch die Ausgestaltung der elektrisch leitenden Kontaktschicht 4 in Form eines flächigen Zwischenkontakts kann außerdem das Aufbringen und Dosieren des Fügewerkstoffs 9 vereinfacht werden. Denn die Kontaktschicht 4 muss hierfür nur in die Paste für den Fügewerkstoff 9 eingetaucht und dann auf die piezokeramische Schicht 3 gelegt werden. Anschließend kann die piezokeramische Schicht 2 aufgelegt werden. Schablonendruckschritte oder dergleichen zum Aufbringen des Fügewerkstoffs 9 sind somit nicht erforderlich.

Allerdings sind auch andere Möglichkeiten zum Aufbringen des Fügewerkstoffs 9 denkbar. Der druckunterstützte Temperaturprozess, insbesondere das Sintern des Fügewerkstoffs 9, muss sich dann unverändert anschließen.

Nach dem Schritt 35 können die Kontaktschichten 5, 6 auf die piezokeramischen Schichten 2, 3 aufgebracht werden. Dies ist beispielsweise durch Metallisieren der piezokeramischen Schichten 2, 3 möglich.

Die Erfindung ist nicht auf die beschriebenen Ausführungsbeispiele beschränkt.

## Patentansprüche

1. Piezoelektrisches Bauteil (1), das als piezoelektrischer Sensor (1) ausgebildet ist, der als Nadelschließsensor oder Drucksensor für Brennstoffeinspritzanlagen oder als Betriebsmittelsensor für Hydraulik- oder Pneumatikanwendungen dient, mit einer ersten piezokeramischen Schicht (2), und genau einer zweiten piezokeramischen Schicht (3) und zumindest einer elektrisch leitenden Kontaktschicht (4), die zumindest teilweise zwischen der ersten piezokeramischen Schicht (2) und der zweiten piezokeramischen Schicht (3) angeordnet ist, wobei die Kontaktschicht (4) über einen Fügewerkstoff (9) zwischen die erste piezokeramische Schicht (2) und die zweite piezokeramische Schicht (3) eingefügt ist und
wobei die Kontaktschicht (4) durch eine Kombination aus einer Druckbeaufschlagung der ersten piezokeramischen Schicht (2) gegen die zweite piezokeramische Schicht (3) und einem Verbinden durch gleichzeitiges Sintern über den Fügewerkstoff (9) zwischen die erste piezokeramische Schicht (2) und die zweite piezokeramische Schicht (3) eingefügt ist.

2. Piezoelektrisches Bauteil nach Anspruch 1,
**dadurch gekennzeichnet,**
**dass** der Fügewerkstoff (9) eine durch die Druckbeaufschlagung beim Sintern beeinflusste Werkstoffstruktur aufweist, die sich aus einer gewählten Druckbeaufschlagung ergibt, die den im Betrieb wirkenden Drücken entspricht.

3. Piezoelektrisches Bauteil nach Anspruch 1 oder 2,
**dadurch gekennzeichnet,**
**dass** der Fügewerkstoff (9) auf Silber oder einer Silberverbindung und/oder einer Silberlegierung basiert oder
**dass** der Fügewerkstoff auf Silber oder einer Silberverbindung und/oder einer Silberlegierung basiert, wobei das Silber beziehungsweise die Silberverbindung und/oder die Silberlegierung durch einen weiteren Werkstoff gefüllt ist.

4. Piezoelektrisches Bauteil nach einem der Ansprüche 1 bis 3,
**dadurch gekennzeichnet,**
**dass** der Fügewerkstoff (9) durch Sintern mit der Kontaktschicht (4) verbunden ist und/oder dass der Fügewerkstoff (9) durch Sintern mit der ersten piezokeramischen Schicht (2) und der zweiten piezokeramischen Schicht (3) verbunden ist.

5. Piezoelektrisches Bauteil nach einem der Ansprüche 1 bis 4, **dadurch gekennzeichnet,**
**dass** die Kontaktschicht (4) aus dem Verbund mit der ersten piezokeramischen Schicht (2) und der zweiten piezokeramischen Schicht (3) ragt.

6. Piezoelektrisches Bauteil nach einem der Ansprüche 1 bis 5,
**dadurch gekennzeichnet,**
**dass** die elektrisch leitende Kontaktschicht (4) durch eine metallische Einlage (4) gebildet ist.

7. Piezoelektrisches Bauteil nach einem der Ansprüche 1 bis 6,
**dadurch gekennzeichnet,**
**dass** die erste piezokeramische Schicht (2) und die zweite piezokeramische Schicht (3) mit der dazwischen eingefügten Kontaktschicht (4) über den Fügewerkstoff (9) mit zumindest näherungsweise deckungsgleichen Verbindungs-Querschnittsflächen verbunden sind.

8. Verfahren zur Herstellung eines piezoelektrischen Bauteils (1), das als piezoelektrischer Sensor (1) ausgebildet ist, der als Nadelschließsensor oder Drucksensor für Brennstoffeinspritzventile oder als Betriebsmittelsensor für Hydraulik- oder Pneumatikanwendungen dient, wobei eine elektrisch leitende Kontaktschicht (4) zumindest teilweise mit einem Fügewerkstoff (9) versehen wird, wobei die mit dem Fügewerkstoff (9) versehene Kontaktschicht (4) zumindest teilweise zwischen einer ersten piezokeramischen Schicht und einer zweiten piezokeramischen Schicht (3) angeordnet wird, wobei die Kontaktschicht (4) über den Fügewerkstoff (9) zwischen die erste piezokeramische Schicht (2) und die zweite piezokeramische Schicht (3) eingefügt wird, und wobei die Kontaktschicht (4) durch eine Kombination aus einer Druckbeaufschlagung der ersten piezokeramischen Schicht (2) gegen die zweite piezokeramische Schicht (3) und einem Verbinden durch gleichzeitiges Sintern über den Fügewerkstoff (9) zwischen die erste piezokeramische Schicht (2) und die zweite piezokeramische Schicht (3) eingefügt wird.

9. Verfahren nach Anspruch 8,
**dadurch gekennzeichnet,**
**dass** die Druckbeaufschlagung beim Sintern so gewählt ist, dass diese den im Betrieb wirkenden Drücken entspricht.

10. Verfahren nach Anspruch 8 oder 9,
**dadurch gekennzeichnet,**
**dass** die elektrisch leitende Kontaktschicht (4) zumindest teilweise in eine zur Ausbildung des Fügewerkstoffs (9) dienenden Paste eingetaucht wird, um die elektrisch leitende Kontaktschicht (4) mit dem Fügewerkstoff (9) zu versehen.

## Claims

1. Piezoelectric component (1) which is configured as a piezoelectric sensor (1) which serves as a needle-closing sensor or as a pressure sensor for fuel injection systems, or as an operating-means sensor for hydraulic or pneumatic applications, having a first piezoceramics layer (2) and precisely one second piezoceramics layer (3) and at least one electrically conducting contact layer (4) which is at least partially disposed between the first piezoceramics layer (2) and the second piezoceramics layer (3), wherein the contact layer (4) by way of a jointing material (9) is inserted between the first piezoceramics layer (2) and the second piezoceramics layer (3), and
wherein the contact layer (4) by a combination of pressure impingement of the first piezoceramics layer (2) against the second piezoceramics layer (3) and by connecting by simultaneous sintering by way of the jointing material (9) is inserted between the first piezoceramics layer (2) and the second piezoceramics layer (3).

2. Piezoelectric component according to Claim 1, **characterized in that** the jointing material (9) has a material structure which is influenced by the pressure impingement during sintering and which results from a selected pressure impingement which corresponds to the pressures acting during operation.

3. Piezoelectric component according to Claim 1 or 2, **characterized in that** the jointing material (9) is based on silver or a silver compound and/or a silver alloy, or **in that** the jointing material is based on silver or a silver compound and/or a silver alloy, wherein the silver or the silver compound, respectively, and/or the silver alloy are/is filled with a further material.

4. Piezoelectric component according to one of Claims 1 to 3, **characterized in that** the jointing material (9) is connected to the contact layer (4) by sintering, and/or **in that** the jointing material (9) is connected to the first piezoceramics layer (2) and to the second piezoceramics layer (3) by sintering.

5. Piezoelectric component according to one of Claims 1 to 4, **characterized in that** the contact layer (4) protrudes from the composite having the first piezoceramics layer (2) and the second piezoceramics layer (3).

6. Piezoelectric component according to one of Claims 1 to 5, **characterized in that** the electrically conducting contact layer (4) is formed by a metallic insert (4).

7. Piezoelectric component according to one of Claims 1 to 6, **characterized in that** the first piezoceramics layer (2) and the second piezoceramics layer (3) having the contact layer (4) inserted therebetween by way of the jointing material (9) are connected having at least approximately congruent connecting cross-sectional areas.

8. Method for producing a piezoelectric component (1) which is configured as a piezoelectric sensor (1) which serves as a needle-closing sensor or as a pressure sensor for fuel injection valves, or as an operating-means sensor for hydraulic or pneumatic applications, wherein an electrically conducting contact layer (4) is at least partially provided with a jointing material (9), wherein the contact layer (4) which is provided with the jointing material (9) is at least partially disposed between a first piezoceramics layer and a second piezoceramics layer (3), wherein the contact layer (4) by way of the jointing material (9) is inserted between the first piezoceramics layer (2) and the second piezoceramics layer (3), and wherein the contact layer (4) by a combination of pressure impingement of the first piezoceramics layer (2) against the second piezoceramics layer (3) and by connecting by simultaneous sintering by way of the jointing material (9) is inserted between the first piezoceramics layer (2) and the second piezoceramics layer (3).

9. Method according to Claim 8, **characterized in that** the pressure impingement during sintering is chosen such that said pressure impingement corresponds to the pressures acting during operation.

10. Method according to Claim 8 or 9, **characterized in that** the electrically conducting contact layer (4) is at least partially dipped in a paste which serves for configuring the jointing material (9), so as to provide the electrically conducting contact layer (4) with the jointing material (9).

## Revendications

1. Composant piézoélectrique (1), qui est conçu comme un capteur piézoélectrique (1), qui sert en tant que capteur de fermeture d'aiguille ou capteur de pression pour installation d'injection de combustible ou en tant que capteur de fluide pour utilisations hydrauliques ou pneumatiques, comportant une première couche piézocéramique (2), et exactement une deuxième couche piézocéramique (3) et au moins une couche de contact conductrice de l'électricité (4), qui au moins partiellement est disposée entre la première couche piézocéramique (2) et la deuxième couche piézocéramique (3), la couche de contact (4) étant par l'intermédiaire d'un matériau d'assemblage (9) insérée entre la première couche piézocéramique (2) et la deuxième couche piézocéramique (3), et
dans lequel la couche de contact (4) est, par une combinaison de l'application d'une pression de la première couche piézocéramique (2) sur la deuxième couche piézocéramique (3) et d'une liaison par frittage simultané par l'intermédiaire du matériau d'assemblage (9), insérée entre la première couche piézocéramique (2) et la deuxième couche piézocéramique (3).

2. Composant piézoélectrique selon la revendication 1, **caractérisé en ce que** le matériau d'assemblage (9) présente une structure de matériau influencée par l'application d'une pression lors du frittage, structure qui correspond à l'application choisie d'une pression, qui correspond aux pressions agissant en cours d'utilisation.

3. Composant piézoélectrique selon la revendication 1 ou 2, **caractérisé en ce que** le matériau d'assemblage (9) est à base d'argent ou d'un composé de l'argent et/ou d'un alliage d'argent, ou **en ce que** le matériau d'assemblage est à base d'argent ou d'un composé de l'argent et/ou d'un alliage d'argent, l'argent, ou le composé de l'argent, et/ou l'alliage d'argent, étant chargés d'un matériau supplémentaire.

4. Composant piézoélectrique selon l'une des revendications 1 à 3, **caractérisé en ce que** le matériau d'assemblage (9) est lié à la couche de contact (4) par frittage, et/ou que le matériau d'assemblage (9) est lié par frittage à la première couche piézocéramique (2) et à la deuxième couche piézocéramique (3).

5. Composant piézoélectrique selon l'une des revendications 1 à 4, **caractérisé en ce que** la couche de contact (4) dépasse du composite constitué de la première couche piézocéramique (2) et de la deuxième couche piézocéramique (3).

6. Composant piézoélectrique selon l'une des revendications 1 à 5, **caractérisé en ce que** la couche de contact conductrice de l'électricité (4) est formée d'un insert métallique (4).

7. Composant piézoélectrique selon l'une des revendications 1 à 6, **caractérisé en ce que** la première couche piézocéramique (2) et la deuxième couche piézocéramique (3), avec la couche de contact (4) insérée entre elles, sont par l'intermédiaire du matériau d'assemblage (9) liées à des surfaces en section transversale de liaison, au moins approximativement en recouvrement.

8. Procédé de fabrication d'un composant piézoélectrique (1), qui est configuré comme un capteur piézoélectrique (1) qui sert de capteur de fermeture d'aiguille ou de capteur de pression pour des soupapes d'injection de carburant ou en tant que capteur de fluide pour des applications hydrauliques ou pneumatiques, dans lequel on pourvoit au moins partiellement d'un matériau d'assemblage (9) une couche de contact conductrice de l'électricité (4), la couche de contact (4) pourvue du matériau d'assemblage (9) étant au moins partiellement disposée entre une première couche piézocéramique et une deuxième couche piézocéramique (3), la couche de contact (4) étant par l'intermédiaire du matériau d'assemblage (9) insérée entre la première couche piézocéramique (2) et la deuxième couche piézocéramique (3), et la couche de contact (4) étant, par une combinaison d'une application de pression de la première couche piézocéramique (2) sur la deuxième couche piézocéramique (3) et d'une liaison par frittage simultané, insérée par l'intermédiaire du matériau d'assemblage (9) entre la première couche piézocéramique (2) et la deuxième couche piézocéramique (3).

9. Procédé selon la revendication 8, **caractérisé en ce que** l'application de pression lors du frittage est choisie de façon qu'elle corresponde aux pressions agissant en cours d'utilisation.

10. Procédé selon la revendication 8 ou 9, **caractérisé en ce que** la couche de contact conductrice de l'électricité (4) est au moins partiellement immergée dans une pâte servant à la formation du matériau d'assemblage (9), pour pourvoir du matériau d'assemblage (9) la couche de contact conductrice de l'électricité (4).
